# EUROPEAN PATENT APPLICATION

(11) **EP 0 982 630 A2**
(43) Date of publication of application: **01.03.2000**
(21) Application number: 99116397.3
(22) Date of filing: 20.08.1999
(51) Int. Cl.: G03F 7/30

(54) **Semiconductor-device manufacturing method having resist-film developing process according to wet treatment**

(30) Priority: 21.08.1998 JP 23513398
(71) Applicant: NEC CORPORATION, Tokyo (JP)
(72) Inventor: Nomura, Yoichi NEC Corporation, Minato-ku, Tokyo (JP)
(74) Representative: Glawe, Delfs, Moll & Partner

(57) **Abstract**

A developing art superior in development uniformity and mask linearity characteristic of a resist film and a superior semiconductor device are provided.

The steps of forming a resist film on a semiconductor substrate, exposing the resist film with a predetermined pattern, and supplying a developer from a nozzle onto the resist film to develop the exposed resist film and the developer is supplied while moving the nozzle above the semiconductor substrate.

## Description

### BACKGROUND OF THE INVENTION

### Field of the Invention

The present invention relates to a semiconductor-device manufacturing method, particularly to a semiconductor-device manufacturing method having a resist-film developing process according to wet treatment.

### Description of the Related Art

To manufacture a semiconductor device, a process is used which patterns an insulating film (e.g. oxide film) or a conductive film (e.g. metallic film made of copper or aluminum) with a specific pattern.

Generally in the patterning step, (1) a photoresist film is formed on a semiconductor substrate, (2) a mask having a predetermined pattern is overlapped to expose the photoresist film, (3) a portion of the photoresist film irradiated or not irradiated with light is removed by melting it through development to form a window portion, and (4) an insulating film or conductive film exposed from the window portion of the photoresist film is removed through etching.

For the above developing process, a wet developing method using a developer or a dry developing method using gas plasma is used. However, at present, the wet developing method is used from the viewpoint of cost.

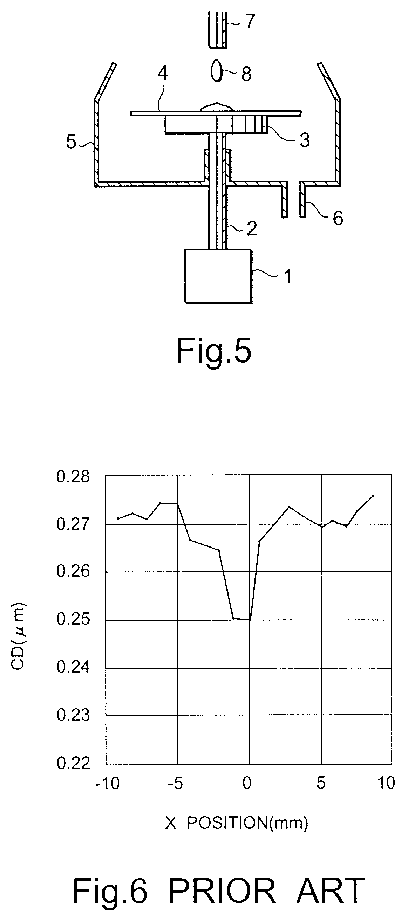

This wet developing method will be briefly described below by referring to the spray-type developing apparatus in Fig. 5.

In Fig. 5, symbol 1 denotes a rotation motor, 2 denotes a rotation axis, and 3 denotes a rotation head. The rotation head 3 is provided with an attracting and holding mechanism for attracting and holding a semiconductor substrate (wafer) 4. Symbol 5 denotes a cup for storing the rotation head 3 and a discharge port 6 is provided for the bottom of the cup 5.

In case of the above apparatus, the semiconductor substrate 4 is attracted to and held on the rotation head 3. The semiconductor substrate 4 is provided with an exposed photoresist film.

Fig. 9 shows steps of the developing process according to the conventional wet developing method.

First, in the process of Step 1, the nozzle of a developer is set to the center of a wafer. Then, in the process of Step 2, the developer (chemical etching solution) 8 is dripped (sprayed) onto the center of the semiconductor substrate 4 from the nozzle 7. While dripping the developer, a wafer is rotated at 1,500 rpm so that the developer spreads on the entire surface of the wafer. Then, in the processes of Steps 3 and 4, the rotation number of the wafer is lowered up to 100 to 20 rpm to pour the developer on the wafer. Thereafter, the rotation of the wafer is stopped to keep the developer poured state for approx. 60 sec in the processes of Steps 5 to 8. The process of rinsing is performed by rotating the wafer at 1,000 rpm while washing away the developer with demineralized water to perform the rinsing process. After rinsing the wafer, the wafer is rotated at a high speed (4,000 rpm) in the process of Step 10 to remove remaining water drops from the wafer. After water drops are completely washed away from the wafer, the wafer is transferred into a hot plate and post-baked.

It is a general method to perform development as described above. However, the development according to the general method has a problem that a preferable development uniformity cannot be obtained.

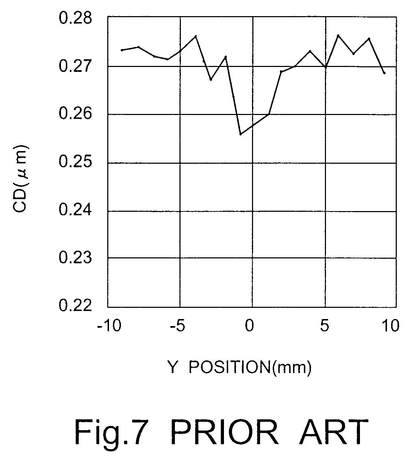

Figs. 6 and 7 show the development uniformity of an 8 inch wafer when a mask of 0.30-µm L&S (Line and Space) is used. In Fig. 6, x-axis shows position (X position) parallel with the orientation flat of the semiconductor substrate 4 and y-axis shows width CD (Critical Dimension) of a pattern formed through development. In Fig. 7, x-axis shows position (Y position) vertical to the orientation flat of the semiconductor substrate 4 and y-axis shows width CD of a pattern formed through development. From Figs. 6 and 7, it is found that development at the central portion, that is, at the central portion to which the developer is dripped is greatly progressed. That is, the pattern width at the central portion is as small as 0.25 to 0.26 µm but the pattern width at the circumference is as large as 0.27 to 0.28 µm.

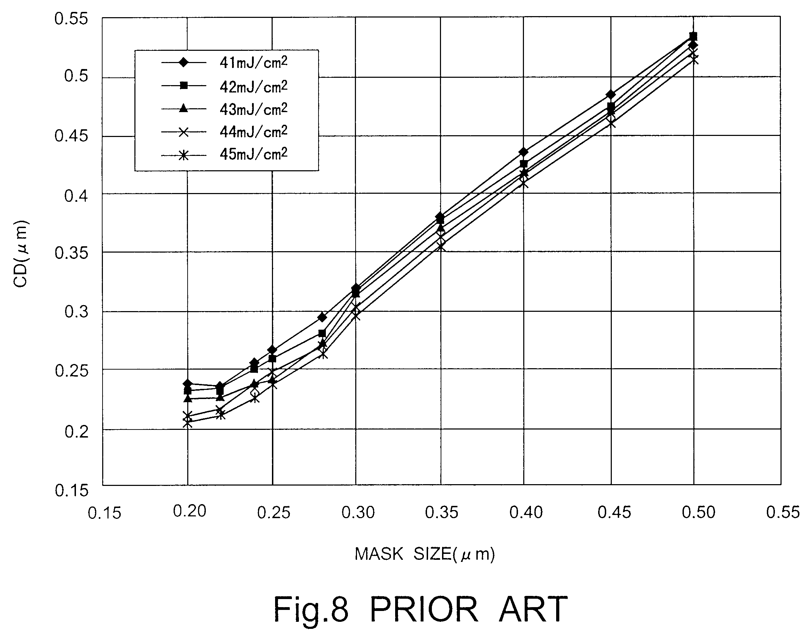

Moreover, Fig. 8 shows the mask linearity characteristic (relation between mask size and width of developed pattern) when assuming the energy under exposure as 41 mJ/cm² to 45 mJ/cm². The mask linearity characteristic is preferable when meeting the relation of y=x. However, it is not very preferable in case of the prior art as shown in Fig. 8.

### SUMMARY OF THE INVENTION

Therefore, it is an object of the present invention to provide a development art superior in development uniformity and mask linearity characteristic of a resist film and a superior semiconductor device.

It is found as the result of study by the present inventor that problems of development uniformity and mask linearity characteristic are caused by the fact that the solubility of resist is raised by a developer.

That is, a conventional photoresist used when using a super-high pressure mercury lamp (i-beam: 365 nm) as an exposure source generally uses cresol novolac resin.

However, because finer micromachining has been requested, an excimer laser (KrF: 248 nm) is proposed as an exposure source and a polyhydroxystyrene derivative (e.g. TDUR-P007 made by TOKYO OHKA KOGYO CO., LTD.) is recently proposed as resist.

Incidentally, it is found that the solubility of the polyhydroxystyrene derivative is raised by a developer (that is, having a high development rate). Moreover, it is found that, when a developer is concentrically dripped to the central portion of a wafer, the development of the portion concentrically progresses and the development uniformity and mask linearity characteristic are deteriorated.

The present invention is made in accordance with the above knowledge and has the following features.

A semiconductor-device manufacturing method of the present invention comprises: forming a resist film on a semiconductor substrate; exposing the resist film with a predetermined pattern; and supplying a developer onto the resist film from a nozzle, in which said nozzle is moved while the developer is supplied.

It is preferable that the moving speed of the nozzle is equal to 200 mm/sec.

It is preferable to rotate the semiconductor substrate at 40 rpm or less when the developer is supplied.

It is preferable to move the nozzle from the position above the edge portion of the semiconductor substrate toward the position above the central portion of it.

According to the above method of the present invention, the developer can be uniformity supplied on the semiconductor substrate and the development uniformity progresses. Therefore, this invention makes it possible to decrease the fluctuation of a dimension in a wafer that the width of a developed pattern decreases at the central portion compared to the circumferential portion and realize high-accuracy development.

### BRIEF DESCRIPTION OF THE DRAWINGS

The above and other objects, advantages and features of the present invention will be more apparent from the following description taken in conjunction with the accompanying drawings, in which:

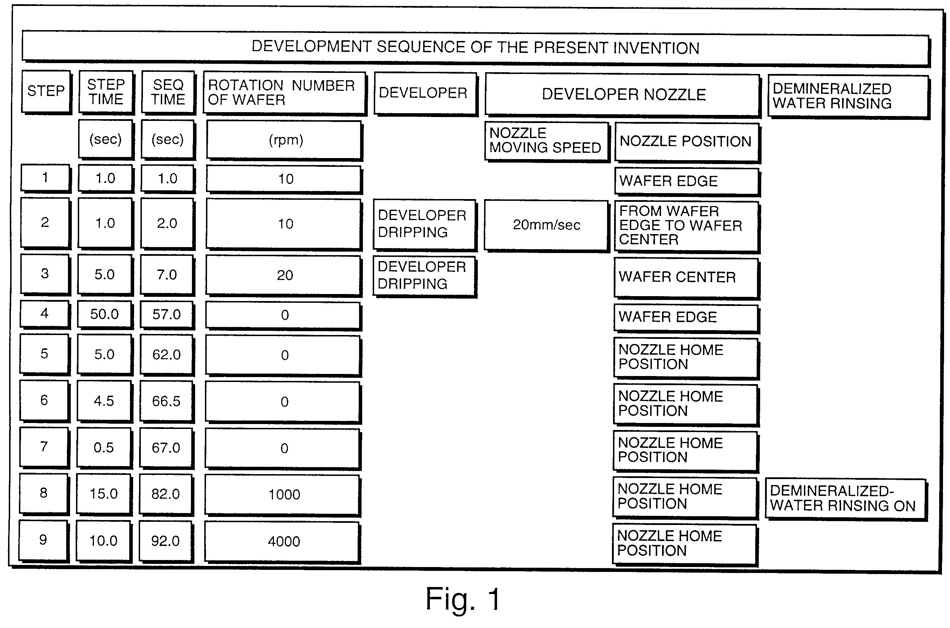

Fig. 1 is a development sequence of the present invention;

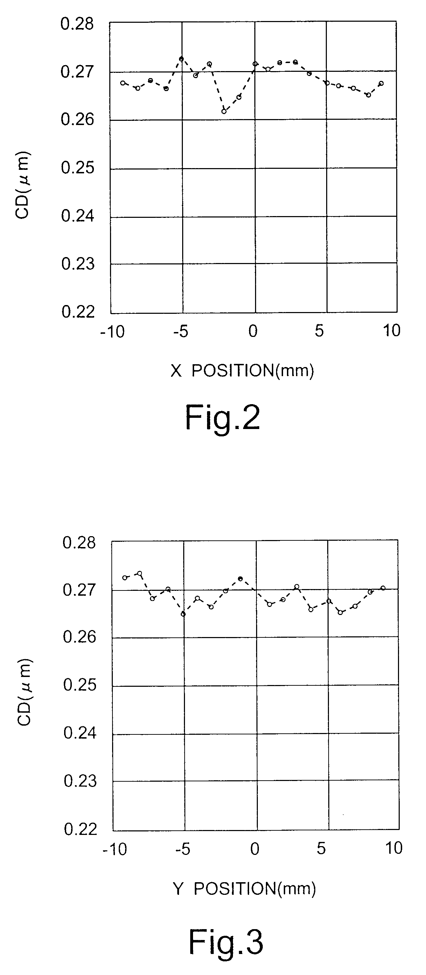

Fig. 2 is a graph showing the development uniformity in a direction parallel with orientation flat when embodying the present invention;
Fig. 3 is a graph showing the development uniformity in a direction vertical to orientation flat when embodying the present invention;

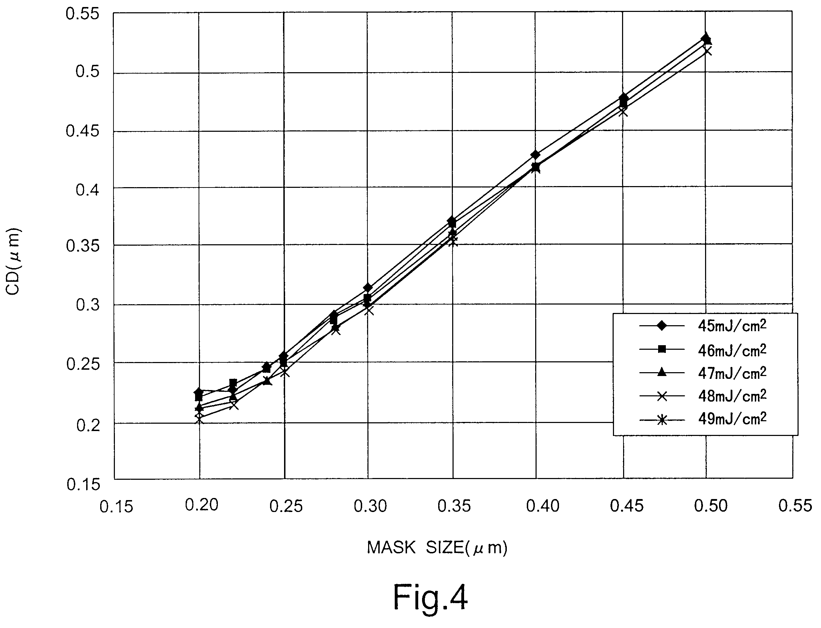

Fig. 4 is a graph showing the mask linearity characteristic of development when embodying the present invention;
Fig. 5 is a schematic view of a developing apparatus;
Fig. 6 is a graph showing the development uniformity in a direction parallel with orientation flat when embodying a conventional method;
Fig. 7 is a graph showing the development uniformity in a direction vertical to orientation flat when embodying a conventional method;
Fig. 8 is a graph showing the mask linearity characteristic of development when embodying a conventional method; and

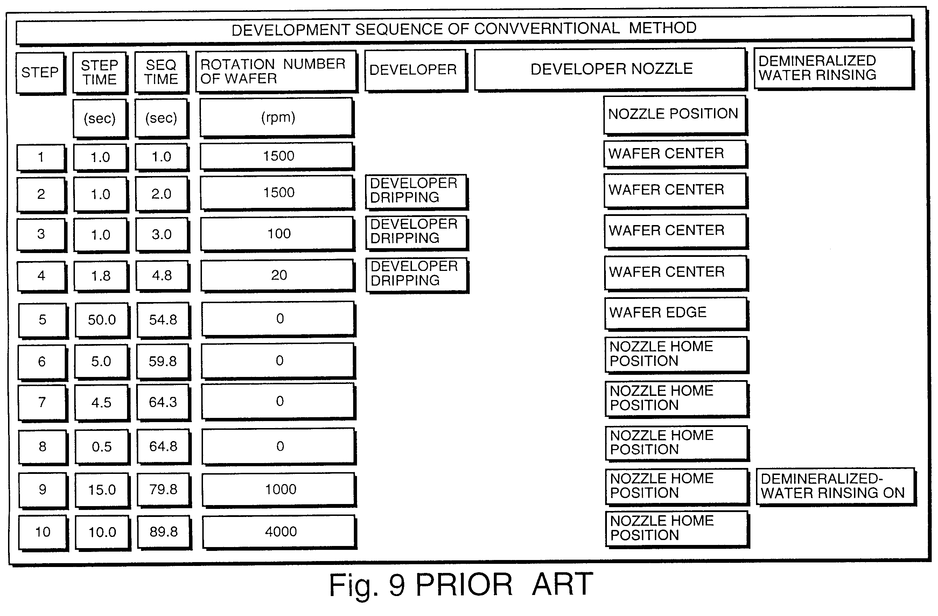

Fig. 9 is a development sequence of a conventional method.

### DESCRIPTION OF THE PREFERRED EMBODIMENTS

A semiconductor-device manufacturing method of the present invention will be described below by referring to Fig. 1.

Detailed description of the stage before the development step, that is, the film-formation step of forming a resist (TDUR-P007 made by TOKYO OHKA CO., LTD. which is a polyhydroxystyrene derivative) film on a semiconductor substrate and the exposure step of exposing a photoresist film by using an excimer laser (KrF: 248 nm) is omitted because the steps are basically the same as the conventional film formation step and exposure step.

An exposed wafer is attracted onto and held by a spray-type rotation head 3 same as that in Fig. 5 and thereafter, a developer nozzle 7 is set onto the end of the wafer (edge portion of the wafer) as shown by Step 1 in Fig. 1. In this case, rotation of the water is started at 10 rpm.

Then, as shown in Step 2, the nozzle 7 is moved from the position above the wafer edge portion to the position above the wafer center while rotating the wafer at 10 rpm and dripping a developer. In this case, the nozzle moving speed is set to 20 mm/sec.

The nozzle 7 moved to the position above the wafer center in Step 2 stops at the position above the wafer center in Step 3 to continue dripping the developer. The rotation number of the wafer during the above period is set to 20 rpm. Thereby, the developer spreads on the entire surface of the wafer.

In Step 2 and 3, the supply of the developer is 1L/min and the total quantity of the developer is 100cc for 8 inch wafer.

The development rate of the resist film passing through the excimer-laser exposure step by a tetramethylammonium-hydroxide aqueous solution is equal to approx. 8 Å/sec when the energy for exposure is equal to 1 mJ/cm², approx. 10 Å/sec when the energy is equal to 10 mJ/cm², and approx. 8,000 Å/sec when the energy is equal to 100 mJ/cm².

While the developer is spread on the entire surface of this wafer, the rotation of the wafer is stopped and held for approx. 60 sec (Steps 4, 5, 6, and 7). During the above period, the nozzle 7 returns from the wafer center to the wafer edge and moreover, it is returned to the home position.

Then, the wafer is rotated at a high speed (1,000 rpm) for approx. 15 sec. (Step 8). In this case, the developer is washed away by demineralized water to rinse the wafer.

After rinsing the wafer, the rotation number of the wafer is raised up to 4,000 rpm to remove remaining water drops (Step 9).

Thereafter, the wafer is transferred to a hot plate and post-baked.

The development uniformity and mask linearity characteristic of samples developed as described above are examined. The results are shown in Figs. 2, 3, and 4. Fig. 4 shows the mask linearity characteristic when setting the energy for exposure to 45 mJ/cm² to 49 mJ/cm².

As apparent from the comparison between Figs. 2 and 6 and between Figs. 3 and 7, it is found that a developing method of the present invention is superior in development uniformity. That is, there is no large difference between the central portion and the circumference portion. That is, it is found that development almost uniformly progresses as a whole.

Moreover, though the development fluctuation of 25 wafers is 25-nm Range in case of a conventional method, it is kept at 12-nm Range in case of the present invention. Therefore, the fluctuation is further improved.

Furthermore, the mask linearity characteristics is rich in linearity as shown in Fig. 4. Furthermore, it is found from Fig. 4 that the present invention makes it possible to accurately develop a mask pattern up to the case of 20-µm L&S.

Incidentally, the optimum exposure values when using a mask pattern of 0.25-µm L&S is 46 mJ/cm² in case of the present invention and 43 mJ/cm² in case of a conventional method.

The exposure step of a semiconductor-device manufacturing method of the present invention is performed by using light having a short wavelength of 248 nm or less, for example, electromagnetic waves such as an excimer-laser beam (KrF: 248) or X-rays. Moreover, it is possible to use a super-high pressure mercury lamp (i-beam: 365 nm). By using an excimer-laser beam instead of an i-beam, a better advantage (micro-machining) of the present invention can be obtained.

Furthermore, the present invention shows a particularly large advantage when a resist film uses a resin having a straight-chain skeleton such as polyhydroxystyrene or its derivative. Furthermore, a developer us es, for example, a tetramethylammoninum-hydroxide aqueous solution. That is, when using resist whose solubility is raised due to the developer (development rate is at least 1 Å/sec under an unexposed state), a large advantage can be obtained by applying the present invention.

Though the moving speed of a nozzle is set to 20 mm/sec, it is not restricted to 20 mm/sec. However, when the moving speed is too high, a developer does not easily spread on the entire surface of a wafer. Therefore, it is preferable to set the moving speed to 1 to 200 mm/sec, particularly to 5 to 100 mm/sec.

Moreover, it is preferable that a semiconductor substrate rates when a developer is supplied onto a resist film. Thereby, the developer is supplied to the entire surface of the semiconductor substrate. However, when the rotation number of the semiconductor substrate is too high, the developer does not easily spread on the entire surface of a wafer. Therefore, it is preferable to set the rotation number to 1 to 40 rpm, particularly to 5 to 30 rpm.

In case of the above embodiment, the nozzle 7 is moved from the outside (edge portion) of a wafer to the center of it. However, it is also possible to move the nozzle 7 from the central portion of a wafer to the edge portion of it.

According to the present invention, because development is not greatly fluctuated and it is superior in mask linearity characteristic, it is possible to develop a resist film at a high accuracy (high resolution) and obtain a high-reliability superior semiconductor device at a high yield.

It is apparent that the present invention is not limited to the above embodiments, but may be modified and changed without departing from the scope and spirit of the invention.

## Claims

1. A manufacturing method of semiconductor device comprising:
forming a resist film on a semiconductor substrate;
exposing said resist film with a predetermined pattern; and
developing said resist film by supplying a developer from a nozzle onto said resist film; wherein
said nozzle is moved while said developer is supplied.

2. The manufacturing method of semiconductor device according to claim 1, wherein said nozzle is moved at a speed of 200 mm/sec or less.

3. The manufacturing method of semiconductor device according to claim 1, wherein the semiconductor substrate rotates while the developer is supplied.

4. The manufacturing method of semiconductor device according to claim 3, wherein said rotation number of said semiconductor substrate is 40 rpm or less.

5. The manufacturing method of semiconductor device according to claim 1, wherein said nozzle is moved from a position above an edge portion of said semiconductor substrate toward a position above a central portion of said semiconductor substrate.

6. The manufacturing method of semiconductor device, wherein a development rate of said resist film under an unexposed state is 1 Å/sec or less.

7. The manufacturing method of semiconductor device according to claim 1, wherein said exposing said resist film is performed by light having a short wavelength of 248 nm or less or electromagnetic waves in the exposure step.

8. The manufacturing method of semiconductor device according to claim 1, wherein said resist film is a resin having a straight-chain skeleton.

9. A manufacturing method of semiconductor device comprising:
forming a resist film on a semiconductor substrate;
exposing said resist film with a predetermined pattern;
dripping a developer onto said resist film from a nozzle while rotating said semiconductor substrate at a first speed and moving said nozzle from a position above an end of said semiconductor substrate to a position above a central portion of said semiconductor substrate; and
dripping a developer onto said resist film from said nozzle by rotating said semiconductor substrate at a second speed higher than said first speed and fixing said nozzle to said position above said central portion of said semiconductor substrate.

10. A manufacturing method of semiconductor device comprising:
exposing a resist film on a semiconductor substrate; and
developing said resist film by supplying a developer from a nozzle onto said resist film; wherein
said developer is supplied while said nozzle is moved so that said developing uniformly progresses.

11. The manufacturing method of semiconductor device according to claim 2, wherein a supply of said developer is 1L/min.
